# FASCICULE DE BREVET EUROPEEN

(11) **EP 3 351 069 B1**
(45) Date de publication et mention de la délivrance du brevet: **19.06.2019**
(21) Numéro de dépôt: 16769940.4
(22) Date de dépôt: 15.09.2016
(51) Int. Cl.: H05K 5/00

(54) **SYSTEME ELECTRONIQUE COMPACT ET DISPOSITIF COMPRENANT UN TEL SYSTEME**
KOMPAKTES ELEKTRONISCHES SYSTEM UND VORRICHTUNG MIT SOLCH EINEM SYSTEM
COMPACT ELECTRONIC SYSTEM AND DEVICE COMPRISING SUCH A SYSTEM

(30) Priorité: 15.09.2015 FR 1558630
(43) Date de publication de la demande: 25.07.2018
(73) Titulaire: Safran Electronics & Defense, 92100 Boulogne-Billancourt (FR)
(72) Inventeur: RIOU, Jean-Christophe, 92100 Boulogne Billancourt (FR)
(74) Mandataire: Lavialle, Bruno François Stéphane
(86) Numéro de dépôt international: PCT/EP2016/071869
(87) Numéro de publication internationale: WO 2017/046269

(56) Documents cités:
- EP-A1- 0 657 121
- EP-A1- 0 844 899
- EP-A2- 2 019 009
- DE-A1- 4 340 280
- FR-A1- 2 980 932

## Description

La présente invention concerne le domaine des composants électroniques.

### ETAT DE LA TECHNIQUE

Les composants montés en surface (technologie classiquement appelée CMS ou SOC) sont brasés à la surface d'une carte à circuit imprimé (ou PCB). Les composants sont généralement contenus dans des boîtiers qui constituent des supports pour les composants et incorporent des conducteurs reliant électriquement les composants au circuit imprimé de la carte.

Le boîtier comprend couramment un fond en saillie duquel s'étend un rebord périphérique définissant un logement pour le composant. Le fond est traversé par les conducteurs électriques qui ont une extrémité en contact avec les plages conductrices du composant et une extrémité opposée destinée à venir en contact avec le circuit imprimé. On parle alors de système en boîtier ou, plus couramment, SIP (de l'anglais « system in package »).

Dans certaines applications, il est nécessaire d'enfermer le composant dans une enceinte étanche définie par une enveloppe externe. Le système, c'est-à-dire le composant dans son boîtier, est alors disposé tout entier dans ladite enceinte, des conducteurs traversant l'enveloppe de façon étanche pour relier le système au circuit imprimé de la carte.

L'encombrement de l'ensemble est alors relativement important et la réalisation des connexions relativement complexe. EP0844899 divulgue un système électronique comprenant un composant électronique fermé hermétiquement dans une boîtier.

### OBJET DE L'INVENTION

Un but de l'invention est de fournir un composant électronique étanche et relativement compact.

### BREF EXPOSE DE L'INVENTION

A cet effet, on prévoit, selon l'invention, un système électronique comprenant au moins un composant, deux boîtiers identiques comportant un fond en saillie duquel s'étend un rebord périphérique définissant un logement, et des conducteurs électriques traversant chaque boîtier. Les boîtiers sont fixés l'un à l'autre par leur rebord pour définir entre eux une cavité étanche.

L'invention a également pour objet un dispositif comportant au moins deux systèmes électroniques ayant des conducteurs traversant le fond de chaque boîtier en ayant une extrémité débouchant sur le fond du boîtier à l'extérieur de celui-ci et une extrémité en saillie dans le logement du boîtier et raccordée au composant, les deux systèmes étant superposés et électriquement reliés l'un à l'autre par les conducteurs du boîtier supérieur du système inférieur et les conducteurs du boîtier inférieur du système supérieur.

D'autres caractéristiques et avantages de l'invention ressortiront à la lecture de la description qui suit de modes de réalisation particuliers non limitatifs de l'invention.

### BREVE DESCRIPTION DES FIGURES

Il sera fait référence aux dessins annexés, parmi lesquels :
- la figure 1 est une vue en perspective éclatée d'un système selon un premier mode de réalisation ;
- la figure 2 est une vue en élévation et en coupe partielle de ce système ;
- la figure 3 est une vue partielle en coupe d'un système selon une variante du premier mode de réalisation ;
- la figure 4 est une vue partielle en coupe d'un système selon un deuxième mode de réalisation ;
- la figure 5 est une vue en perspective éclatée d'un dispositif comprenant deux systèmes ;
- la figure 6 est une vue en élévation et en coupe partielle de ce système.

### DESCRIPTION DETAILLEE DE L'INVENTION

En référence aux figures, le système électronique selon l'invention, généralement désigné en 1, comprend deux boîtiers identiques 2 (identifiés individuellement sur les figures par les lettres A, B).

Chaque boîtier 2 comporte un fond 3 en saillie duquel s'étend un rebord périphérique 4 définissant un logement 5. Des conducteurs électriques 6 traversent chaque boîtier 2. Plus précisément, les conducteurs électriques 6 sont agencés en matrice et traversent le fond 3 de chaque boîtier 2 et ont une extrémité débouchant dans le logement 5 et une extrémité opposée débouchant sur une surface externe du fond 3 à l'opposé du logement 5. Les conducteurs électriques 6 sont ici des broches et les boîtiers 2 sont ici de type CPGA74. En variante, les conducteurs électriques peuvent être des billes (boîtiers de type BGA), des colonnes (boîtiers de type CGA), ou des pastilles (boîtiers de type LGA).

Les boîtiers 2A, 2B sont fixés l'un à l'autre par leur rebord 4 pour définir entre eux une cavité étanche.

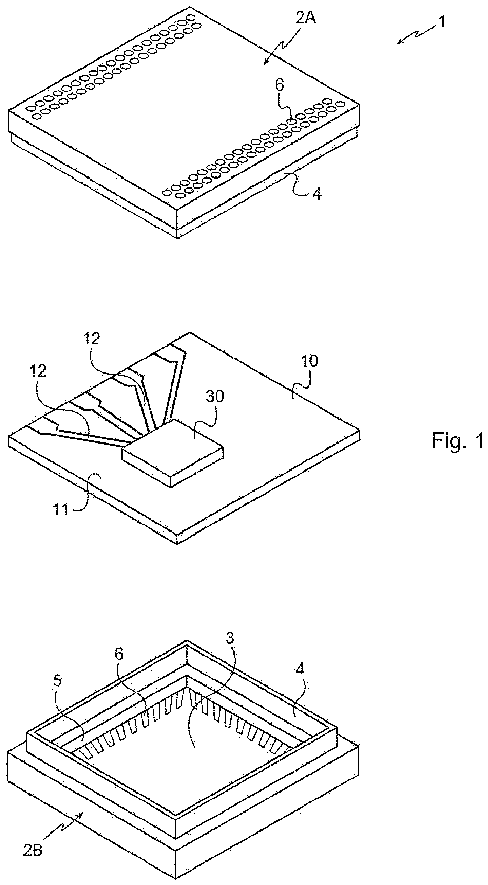

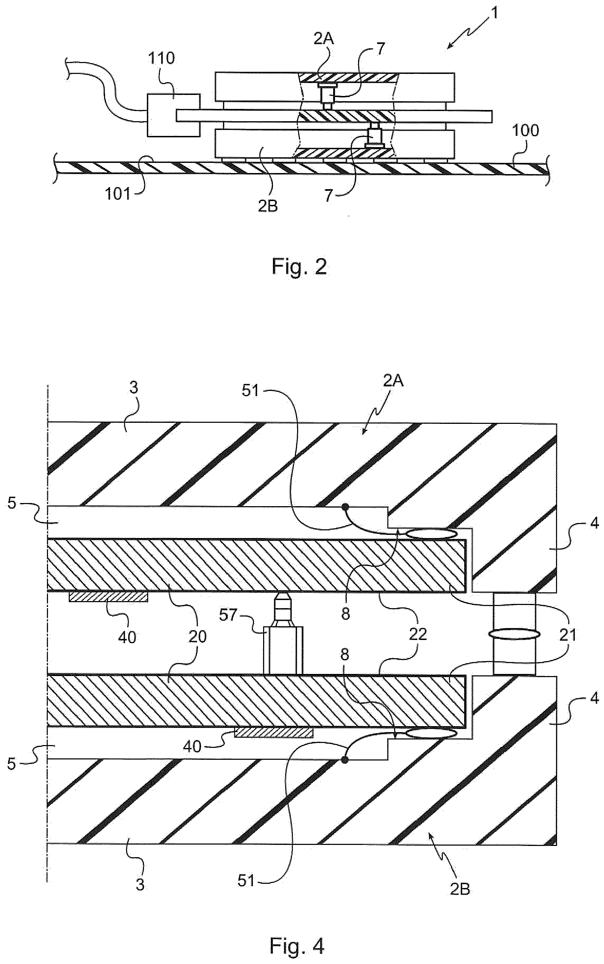

En référence plus particulièrement aux figures 1 et 2 et selon le premier mode de réalisation, le système 1 comprend un substrat 10 en forme de plaque s'étendant entre les rebords 4 des boîtiers 2, les rebords 4 étant fixés (ici par brasage) au substrat 10 qui permet la solidarisation des boîtiers 2 l'un à l'autre. Le substrat 10 a un bord périphérique 11 qui s'étend en saillie latérale des rebords 4 des boîtiers 2.

Le substrat 10 a une surface portant un composant électronique 30 et comporte des pistes conductrices 12 qui ont des plages de contact électriquement reliées au composant électronique 30 et des plages de contact s'étendant sur une portion du bord périphérique 11 du substrat 10. Le substrat 10 est un substrat céramique en couche épaisse et double face.

Le substrat 10 sépare les logements 5 de telle manière que le logement 5 de chaque boîtier 2 forme une cavité étanche. Le composant électronique 30 est logé dans une des cavités étanches. Le substrat 10 peut porter un composant électronique 30 sur ses deux faces de sorte que chaque composant électronique 30 soit logé dans une des cavités étanches.

Comme représenté sur la figure 2, le système est monté sur une carte à circuit imprimé 100 (ou PCB) portant des pistes conductrices 101 raccordées aux conducteurs électriques 6 (montage en surface ou SOC). Un connecteur 110 relié à un équipement non représenté est engagé sur le bord périphérique 11 pour raccorder l'équipement au composant électronique 30 via les plages de contact des pistes conductrices 12.

Des connecteurs à piston 7 relient ici les conducteurs électriques 6 des boîtiers 2 à des pistes conductrices 12 du substrat 10.

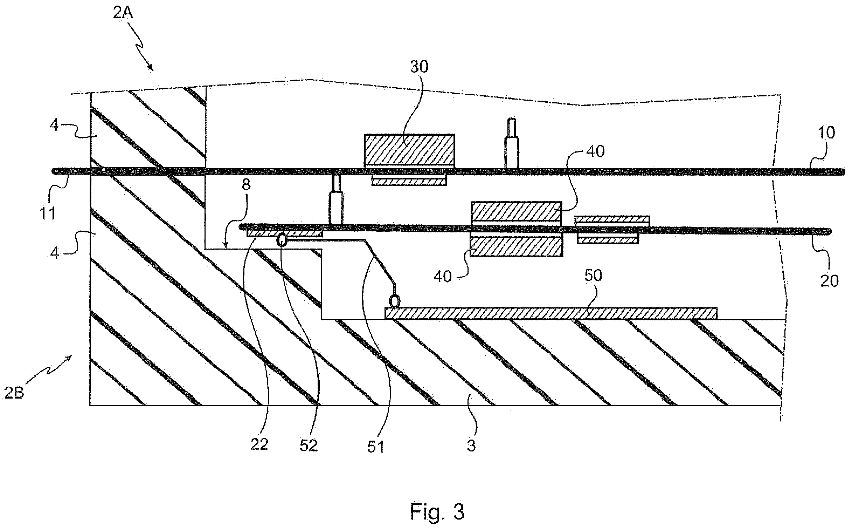

Dans la variante de la figure 3, le système comprend un deuxième substrat 20 qui a une surface portant un composant électronique 40 et comporte des pistes conductrices 22. Le substrat 20 est un substrat céramique en couche épaisse.

Le substrat 20 est monté dans le logement 5 du boîtier 2A et a un rebord périphérique 21 reposant sur un épaulement 8 du rebord 4 du boîtier 2A pour s'étendre parallèlement au substrat 10 et au fond 3.

Le système 1 comprend des premiers moyens de raccordement reliant les pistes conductrices 22 du substrat 20 aux conducteurs électriques 6 du boîtier 2A et des deuxièmes moyens de raccordement des pistes conductrices 22 du substrat 20 aux pistes conductrices 12 du substrat 10. Les premiers moyens de raccordement comprennent des pistes conductrices 50 s'étendant sur le fond 3 du boîtier 2A et des fils de liaison 51 ayant chacun une extrémité fixée à une des pistes conductrices 50 et une extrémité opposée reliée par une bille 52 à une des pistes 22 pour raccorder ces pistes conductrices 50 aux pistes conductrices 22.

Les moyens de raccordement peuvent également comprendre des pistes conductrices s'étendant le long du rebord 4, ou dans celui-ci, depuis le fond 3 pour raccorder les conducteurs 6 aux pistes conductrices 22 et/ou aux pistes conductrices 12.

En référence plus particulièrement à la figure 4, et selon le deuxième mode de réalisation, le système 1 comprend deux boîtiers 2 comme précédemment mais est dépourvu de substrat central 10. Les rebords 4 des boîtiers 2 sont directement brasés l'un sur l'autre.

Le système selon le deuxième mode de réalisation comprend deux substrats 20 qui sont montés chacun dans le logement 5 d'un des boîtiers 2 à distance du fond 3 dudit boîtier 2 et ont chacun un rebord périphérique 21 reposant sur un épaulement 7 du rebord 4 du boîtier 2 pour s'étendre parallèlement au fond 3.

Chaque substrat 20 porte un composant électronique 40 et est pourvu de pistes conductrices 22 reliées au composant électronique 40.

Le système comprend ici des premiers moyens de raccordement reliant les pistes conductrices 22 de chaque substrat 20 aux conducteurs électriques 6 du boîtier 2 auquel il est fixé et des deuxièmes moyens de raccordement de pistes conductrices 22 de l'un des substrats 20 à des pistes conductrices 22 de l'autre substrat 20.

Les premiers moyens de raccordement comprennent des fils électriques 51 s'étendant entre les conducteurs électriques 6 et les pistes conductrices 22 concernées.

Les deuxièmes moyens de raccordement comprennent des connecteurs à piston 57 reliant des pistes conductrices 22 du substrat 20 du boîtier 2A à des pistes conductrices 22 du substrat 20 du boîtier 2B.

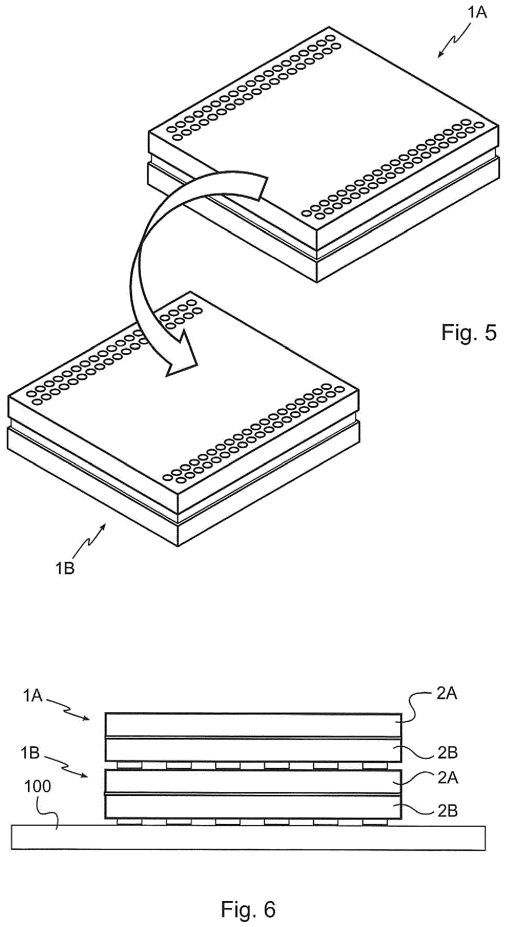

Aux figures 5 et 6 est représenté un dispositif électronique comportant deux systèmes 1A, 1B du type précédent.

Les conducteurs électriques du boîtier 2B du système 1B sont brasés sur les pistes conductrices d'une carte à circuit imprimé 100. Les conducteurs électriques du boîtier 2B du système 1A sont brasés sur les conducteurs électriques du boîtier 2A du système 1B de sorte que les systèmes 1A et 1B sont superposés et électriquement reliés l'un à l'autre.

Le système 1A comporte par exemple un capteur et le système 1B comporte par exemple un circuit électronique de commande du capteur.

Les conducteurs du système 1A débouchant au-dessus du dispositif peuvent par exemple être utilisés pour tester le fonctionnement du dispositif ou pour raccorder une antenne.

Les systèmes sont ainsi superposables mécaniquement et électriquement. Il est possible de prévoir que les cavités des systèmes soient soumises à des milieux (gaz, liquide ou vide) identiques ou différents. Cette superposition permet par exemple d'étendre la fonctionnalité électronique du dispositif ou déporter au moins une première fonction vis-à-vis d'au moins une deuxième fonction.

Bien entendu, l'invention n'est pas limitée aux modes de réalisation décrits mais englobe toute variante entrant dans le champ de l'invention telle que définie par les revendications.

En particulier, le système peut simplement comprendre une cloison séparant les logements 5 de telle manière que le logement de chaque boîtier forme une cavité étanche, le ou les composants électroniques étant logés dans au moins une des cavités étanches. De préférence, le système comprenant deux composants, les composants sont montés dans des cavités étanches différentes.

En variante, le substrat peut avoir un bord périphérique s'étendant en saillie d'un seul côté des rebords 4 des boîtiers 2.

Le substrat est un substrat céramique ou organique.

Il est possible de disposer un absorbeur de gaz dans le logement 5.

On notera que le logement peut accueillir diverses fonctions électroniques en lien éventuellement avec des capteurs, le tout étant arrangé mécaniquement et électriquement dans le logement de manière à permettre une transmission de l'information verticale (3D) et horizontale entre les différents niveaux ou substrats.

## Revendications

1. Système électronique comprenant au moins un composant électronique (30), deux boîtiers identiques (2) comportant un fond (3) en saillie duquel s'étend un rebord périphérique (4) définissant un logement (5), et des conducteurs électriques (6) traversant chaque boîtier, les boîtiers étant fixés l'un à l'autre par leur rebord pour définir entre eux une cavité étanche recevant le composant.

2. Système selon la revendication 1, comportant au moins un premier substrat (10) s'étendant entre les rebords (4) des boîtiers (2), le premier substrat portant le composant (30) et comportant des pistes conductrices (12) reliées au composant.

3. Système selon la revendication 2, dans lequel le premier substrat (10) a un bord périphérique (11) en saillie latérale des rebords (4) des boîtiers (2), les pistes conductrices (12) s'étendant sur une portion du bord périphérique du substrat.

4. Système selon la revendication 3, dans lequel le premier substrat (10) sépare les logements (5) de telle manière que le logement de chaque boîtier forme une cavité étanche, le composant (30) étant logé dans une des cavités étanches.

5. Système selon l'une quelconque des revendications 2 à 4, comprenant au moins un deuxième substrat (20) qui est monté entre le premier substrat (10) et le fond (3) d'un des boîtiers (2) et qui porte un deuxième composant (40), le système comportant des moyens de raccordement électrique de pistes conductrices (22) du deuxième substrat aux conducteurs (6) du boîtier et aux pistes conductrices (12) du premier substrat (10).

6. Système selon la revendication 1, comprenant au moins deux composants montés chacun sur un substrat qui est monté respectivement dans le logement (4) d'un des boîtiers (2) à distance du fond (3) dudit boîtier et qui est pourvu de pistes conductrices reliées au composant, des premiers moyens de raccordement reliant les pistes conductrices de chaque substrat aux conducteurs du boîtier auquel il est fixé et des deuxièmes moyens de raccordement de pistes conductrices de l'un des substrats à des pistes conductrices de l'autre substrat.

7. Système selon l'une quelconque des revendications 2 à 6, dans lequel le substrat (10, 20) est un substrat céramique ou organique.

8. Système selon la revendication 1, comportant des pistes conductrices s'étendant dans le logement d'au moins un des boîtiers sur le fond dudit boîtier et des moyens de raccordement électrique de ces pistes conductrices au composant.

9. Système selon la revendication 1, comprenant une cloison séparant les logements de telle manière que le logement de chaque boîtier forme une cavité étanche, le composant étant logé dans une des cavités étanches.

10. Système selon la revendication 9, comprenant deux composants (40), les composants étant montés dans des cavités étanches différentes.

11. Dispositif électronique comportant deux systèmes selon l'une quelconque des revendications précédentes, les systèmes (1A, 1B) étant superposés l'un sur l'autre, dans lequel au moins une partie des conducteurs de chaque boîtier traverse le fond (3) du boîtier (2) en ayant une extrémité débouchant sur le fond du boîtier à l'extérieur de celui-ci et une extrémité en saillie dans le logement du boîtier et raccordée au composant (30, 40), les deux systèmes étant électriquement reliés l'un à l'autre par les conducteurs du boîtier supérieur du système inférieur et les conducteurs du boîtier inférieur du système supérieur.

## Patentansprüche

1. Elektronisches System, umfassend mindestens ein elektronisches Bauelement (30), zwei identische Gehäuse (2), die einen Boden (3) umfassen, von dem ein Umfangsrand (4) vorsteht, der eine Aufnahme (5) definiert, und elektrische Leiter (6), die durch jedes Gehäuse hindurchgehen, wobei die Gehäuse über ihren Rand aneinander befestigt sind, um zwischen sich einen dichten Hohlraum zu definieren, der das Bauelement aufnimmt.

2. System nach Anspruch 1, umfassend mindestens ein erstes Substrat (10), das sich zwischen den Rändern (4) der Gehäuse (2) erstreckt, wobei das erste Substrat das Bauelement (30) trägt und leitende Bahnen (12) umfasst, die mit dem Bauelement verbunden sind.

3. System nach Anspruch 2, bei dem das erste Substrat (10) einen von den Rändern (4) der Gehäuse (2) seitlich vorstehenden Umfangsrand (11) hat, wobei sich die leitenden Bahnen (12) über einen Abschnitt des Umfangsrandes des Substrats erstrecken.

4. System nach Anspruch 3, bei dem das erste Substrat (10) die Aufnahmen (5) derart trennt, dass die Aufnahme jedes Gehäuses einen dichten Hohlraum bildet, wobei das Bauelement (30) in einem der dichten Hohlräume untergebracht ist.

5. System nach einem der Ansprüche 2 bis 4, umfassend mindestens ein zweites Substrat (20), das zwischen dem ersten Substrat (10) und dem Boden (3) eines der Gehäuse (2) angebracht ist und das ein zweites Bauelement (40) trägt, wobei das System Mittel zur elektrischen Verbindung von leitenden Bahnen (22) des zweiten Substrats mit den Leitern (6) des Gehäuses und mit den leitenden Bahnen (12) des ersten Substrats (10) umfasst.

6. System nach Anspruch 1, umfassend mindestens zwei Bauelemente, die jeweils auf einem Substrat angebracht sind, das jeweils in der Aufnahme (4) eines der Gehäuse (2) mit Abstand zum Boden (3) des genannten Gehäuses angebracht und mit leitenden Bahnen versehen ist, die mit dem Bauelement verbunden sind, wobei erste Verbindungsmittel die leitenden Bahnen jedes Substrats mit den Leitern des Gehäuses verbinden, an dem es befestigt ist, und zweite Verbindungsmittel zum Verbinden leitender Bahnen eines der Substrate mit leitenden Bahnen des anderen Substrats.

7. System nach einem der Ansprüche 2 bis 6, bei dem das Substrat (10, 20) ein keramisches oder organisches Substrat ist.

8. System nach Anspruch 1, umfassend leitende Bahnen, die sich in der Aufnahme mindestens eines der Gehäuse auf dem Boden des Gehäuses erstrecken und Mittel zur elektrischen Verbindung dieser leitenden Bahnen mit dem Bauelement.

9. System nach Anspruch 1, umfassend eine Trennwand, die die Aufnahmen derart trennt, dass die Aufnahme jedes Gehäuses einen dichten Hohlraum bildet, wobei das Bauelement in einem der dichten Hohlräume untergebracht ist.

10. System nach Anspruch 9, umfassend zwei Bauelemente (40), wobei die Bauelemente in unterschiedlichen dichten Hohlräumen angeordnet sind.

11. Elektronische Vorrichtung, umfassend zwei Systeme nach einem der vorhergehenden Ansprüche, wobei die Systeme (1A, 1B) übereinander angeordnet sind, wobei mindestens ein Teil der Leiter jedes Gehäuses durch den Boden (3) des Gehäuses (2) hindurchgeht und dabei ein Ende hat, das auf dem Boden des Gehäuses außerhalb desselben mündet, sowie ein in die Aufnahme des Gehäuses vorstehendes Ende, das mit dem Bauelement (30, 40) verbunden ist, wobei die beiden Systeme elektrisch miteinander über die Leiter des oberen Gehäuses des unteren Systems und die Leiter des unteren Gehäuses des oberen Systems verbunden sind.

## Claims

1. Electronic system comprising at least one electronic component (30), two identical packages (2) including a bottom (3) from which a peripheral rim (4) defining a recess (5) protrudes, and electrical conductors (6) passing through each package, the packages being attached to one another by the rim thereof so as to define a sealed cavity receiving the component.

2. System according to claim 1, including at least one first substrate (10) extending between the rims (4) of the packages (2), the first substrate supporting the component (30) and including conductive tracks (12) connected to the component.

3. System according to claim 2, wherein the first substrate (10) has a peripheral rim (11) projecting sidewise from the rims (4) of the packages (2), the conductive tracks (12) extending over a portion of the peripheral edge of the substrate.

4. System according to claim 3, wherein the first substrate (10) separates the recesses (5) so that the recess of each package forms a sealed cavity, the component (30) being recessed in one of the sealed cavities.

5. System according to any claim 2 to 4, comprising at least one second substrate (20) which is mounted between the first substrate (10) and the bottom (3) of one of the packages (2) and which supports a second component (40), the system including means for electrically connecting conductive tracks (22) of the second substrate to the conductors (6) of the package and to the conductive tracks (12) of the first substrate (10) .

6. System according to claim 1, comprising at least two components mounted each on a substrate which is respectively mounted in the recess (4) of one of the packages (2) at a distance from the bottom (3) of said package and which is provided with conductive tracks connected to the component, first connection means connecting the conductive tracks of each substrate to the conductors of the package to which it is attached and second means for connecting conductive tracks of one of the substrates to conductive tracks of the other substrate.

7. System according to any claim 2 to 6, wherein the substrate (10, 20) is a ceramic or organic substrate.

8. System according to claim 1, including conductive tracks extending in the recess of at least one of the packages on the bottom of said package and means for electrically connecting said conductive tracks to the component.

9. System according to claim 1, comprising a partition separating the recesses so that the recess of each package forms a sealed cavity, the component being recessed in one of the sealed cavities.

10. System according to claim 9, comprising two components (40), the components being mounted in separate sealed cavities.

11. Electronic device including two systems according to any preceding claim, the systems (1A, 1B) being superimposed on one another, wherein at least one portion of the conductors of each package passes through the bottom (3) of the package (2) having one end opening onto the bottom of the package outside same and one end protruding into the recess of the package and connected to the component (30, 40), the two systems being electrically connected to one another by the conductors of the upper package of the lower system and the conductors of the lower package of the upper system.
